# EUROPEAN PATENT APPLICATION

(11) **EP 0 908 942 A2**
(43) Date of publication of application: **14.04.1999**
(21) Application number: 98118127.4
(22) Date of filing: 24.09.1998
(51) Int. Cl.: H01L 21/318, H01L 21/3105

(54) **Improved nitride etch stop layer**

(30) Priority: 30.09.1997 US 940896
(71) Applicant: SIEMENS AKTIENGESELLSCHAFT, 80333 München (DE)
(72) Inventor: Schrems, Martin, 01465 Langebrueck (DE); Wohlfahrt, Joerg, Hopwell Junction, NY 12533 (US); Nuetzel, Joachim, Fishkill, NY 12524 (US)
(74) Representative: Patentanwälte Westphal, Mussgnug & Partner

(57) **Abstract**

Annealing a pad layer in NH₃ or N₂ ambient improves the pad layers resistance to etching and polishing. This results in reduced over-erosion during processing of an integrated circuits, thereby improving yields.

## Description

### Field Of Invention

The invention generally relates to device and device fabrication and, more particularly, to the use of nitride etch stop in device fabrication.

### Background Of Invention

In device fabrication, insulating, semiconducting, and conducting layers are formed on a substrate or wafer. The layers are patterned to create features and spaces, forming devices, such as transistors, capacitors, and resistors. These devices are then interconnected to achieve a desired electrical function, resulting in an integrated circuit (IC) or chip.

A nitride layer is typically used as an etch or polish stop layer to facilitate patterning of the layer or layers. Such nitride layer is referred to as a pad nitride layer. Conventional pad nitride layers are formed by low pressure chemical vapor deposition (LPCVD).

However, conventional pad nitride layers experience excessive erosion during etch or polish processes. For example, the pad nitride layer thickness can be reduced by about 30% in the wafer center and more than 40% near the wafer edge after device processing due to chemical mechanical polish (CMP) and, to a lesser extent, reactive ion etch (RIE) and chemical dry etch (CDE). The excessive erosion can lead to reduced yields.

As apparent from the above discussion, it is desirable to provide an improved etch stop.

### Summary Of Invention

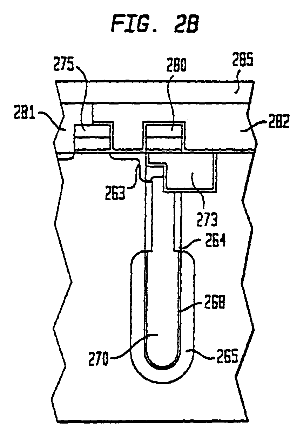

After the trench is formed, conventional processing is employed to form a trench capacitor DRAM cell 260, as shown in Fig. 2b. Such a DRAM cell is described in, for example, Nesbit et al., A 0.6 µm² 256Mb Trench DRAM Cell With Self-Aligned Buried Strap (BEST), IEDM 93-627, which is herein incorporated by reference for all purposes. This includes forming a buried plate 265, a node dielectric 268, a collar 264, a storage node 270, a buried strap 263, a STI 273, gate conductors that represent active and passing wordlines 275 and 280, an interlevel dielectric layer 282, a contact opening 280, and a bitline 285. Typically, an array of such cells are interconnected by wordlines and bitlines to form a DRAM chip.

### Brief Description Of Drawings

Fig. 1 shows a pad nitride layer in accordance with one embodiment of the invention;
Figs. 2a-b show a process of forming a trench capacitor DRAM cell in accordance with one embodiment of the invention; and
Figs 3-4 show experimental results of reduced CMP rate resulting from a pad nitride layer formed in accordance with one embodiment of invention.

### Detailed Description Of The Invention

The present invention relates to an improved pad nitride layer. For purposes of illustration, the present invention is described in the context of a pad stack used in, for example, the fabrication of a trench capacitor DRAM cell. However, the invention is significantly broader and extends to pad nitride layers used in the fabrication of integrated circuits (ICs) in general. Such ICs include, for example, random access memories (RAMs), dynamic RAMs (DRAMs), synchronous DRAMs (SDRAMs), static RAMs (SRAMs), and read only memories (ROMs). Other ICs include logic devices such as programmable logic arrays (PLAs), application specific ICs (ASICs), embedded DRAMs, or other circuit devices. Typically, a plurality of ICs are fabricated on a semiconductor substrate, such as a silicon wafer, in parallel. After processing, the wafer is diced in order to separate the ICs into a plurality of individual chips. The chips are then packaged into final products for use in, for example, consumer products such as computer systems, cellular phones, personal digital assistants (PDAs), and other products.

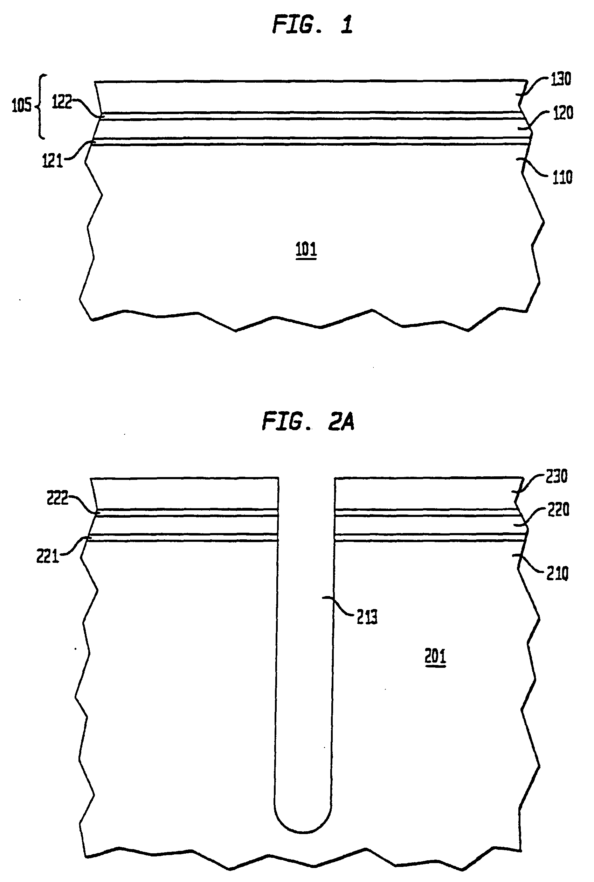

Referring to Fig. 1, a pad stack 105 in accordance with one embodiment of the invention is shown. The pad stack is formed on a substrate 101. The pad stack includes a pad oxide 110, a pad nitride 120, and a deep trench hard etch mask 130. The pad stack is used in the fabrication of deep trench DRAM cells. As shown, the pad nitride comprises a first nitride layer 121 and a second nitride layer 122. The second nitride layer is denser and harder than the first nitride layer 122. By providing a second denser and harder nitride layer, erosion of the pad nitride layer is reduced during processing.

Figs. 2a-b show the process of forming a deep trench DRAM cell, including the formation of the pad stack in accordance with the invention. Referring to Fig. 2a, a substrate 201 is provided on which a DRAM cell is fabricated. The major surface of the substrate is not critical and any suitable orientation such as a (100), (110), or (111) is useful. In an illustrative embodiment, the substrate is lightly doped with dopants of a first conductivity. In one embodiment, the substrate is lightly doped with p-type dopants (p⁻), such as B. The concentration of the B is about 1 - 2 X 10¹⁶ cm⁻³.

The substrate optionally includes a buried well 240 comprising dopants of a second conductivity. In one embodiment, the buried well comprises n-type dopants such as As or P dopants. A mask, for example, is patterned to define the buried well regions. P dopants are then implanted into buried well regions of the substrate. The implant is performed with sufficient energy and dose to deposit the peak concentration of P dopants below the collar that is to be formed. The buried well serves to isolate the P-well from the substrate and also forms a conductive bridge between the buried plates of the capacitors. The concentration and energy of the implant is about > 1 X 10¹³ atoms/cm² at about 1.5 MeV. Alternatively, the buried well is formed by implanting and then growing an epi layer above the substrate surface. Such technique is described in US Patent 5,250,829 to Bronner et al., which is herein incorporated by reference for all purposes.

A pad oxide 210 is formed on the surface of the substrate. Above the pad oxide is a pad nitride 221. The pad nitride, which serves as a polish stop, is deposited by LPCVD. Typically, the thickness of nitride layer 221 is about 200nm. The actual thickness of course depends on the specific application.

In accordance with the invention, the pad nitride layer is annealed in an NH₃ or N₂ ambient to produce a nitride layer 222. Preferably, the anneal is performed in a nitrogen rich ambient. In one embodiment, a rapid thermal anneal (RTA) is performed. The temperature of the RTA is from about 900-1200°C for about 0.01 - 10 minutes in an NH₃ or N₂ ambient. In one embodiment, the RTA is performed at 1150oC for about 3 minutes. Furnace annealing of the nitride layer is also useful. The furnace anneal is performed at a temperature of about 900-1200°C for 1-600 minutes in NH₃ or N₂ ambient. In one embodiment, the furnace anneal is performed at 1100°C for about 60 minutes.

By providing a pad nitride layer with a first layer and a second hardened nitride layer, the etch and polish rate is reduced. As a result, excessive erosion of the pad nitride layer is reduced in subsequent etch and polishing steps. Particularly, over-erosion at the wafer edge compared to the wafer center is avoided. Thus, threshold voltage shifts across the wafer and yield loss is reduced.

A hard mask layer 230 is then formed over nitride layer 222. The hard mask comprises for example TEOS. Other material, such as BSG is also useful for the hard mask layer. Additionally, an anti-reflective coating (ARC) may be used to improve the lithographic resolution.

The hard mask layer is patterned using conventional lithographic techniques to define a region in which the trench is to be formed. Defining the deep trench region includes depositing a layer of resist and selectively exposing it with the desired pattern. The resist is then developed and either the exposed or unexposed portions are removed, depending on whether a positive or negative resist is used. The exposes portions of the pad stack are then etched to the surface of the substrate. A deep trench 213 is formed by reactive ion etch (RIE). If BSG is used as the hard mask, it is removed. This is because the BSG layer can be removed by a wet etch selective to oxide. As such, erosion of the pad oxide at the trench opening is avoided.

After the trench is formed, conventional processing is employed to form a trench capacitor DRAM cell 260, as shown in Fig. 2b. Such a DRAM cell is described in, for example, Nesbit et al., A 0.6 µm² 256Mb Trench DRAM Cell With Self-Aligned Buried Strap (BEST), IEDM 93-627, which is herein incorporated by reference for all purposes. This includes forming a buried plate 265, a node dielectric 268, a collar 264, a storage node 270, a buried strap 263, a STI 273, gate conductors that represent active and passing wordlines 275 and 280, an interlevel dielectric layer 282, a contact opening 280, and a bitline 285. Typically, an array of such cells is interconnected by wordlines and bitlines to form a DRAM chip.

### Example 1

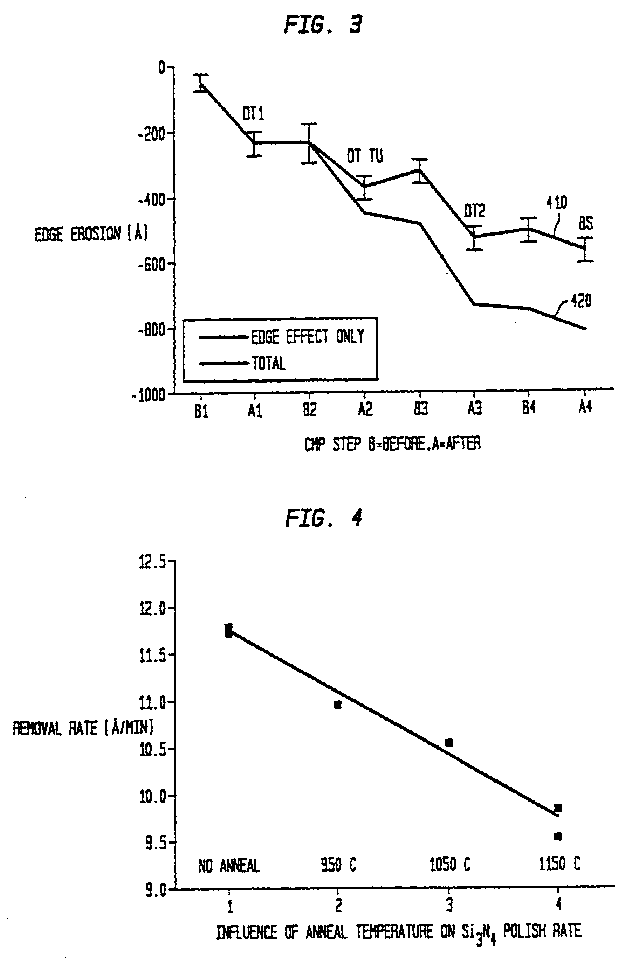

An experiment was conducted to demonstrate the reduced chemical mechanical polish (CMP) rate resulting from annealing the pad layer in a NH₃ anneal The experiment measured the CMP rate of a pad nitride layer with no anneal, an anneal at 950°C, 1050°C, and 1150°C. The results of the experiment are shown in Fig. 3. As can be seen, CMP rate was reduced as a result of the anneal. The CMP rate decreases with increasing annealing temperature and annealing time. An anneal at 1150°C for about 2 minutes shows about a 20% decrease in CMP rate compared to a pad nitride layer with no anneal. Thus, increasing the thermal budget can increase the thickness and hardness of the pad nitride layer, resulting in a decrease in the etch rate.

### Example 2

Fig. 4 shows the difference in erosion of a pad nitride layer with (line 410) and without (line 420) an anneal in a NH₃ or N₂ ambient. The erosion was measured at various polishing steps used to form a deep trench capacitor. As shown, a greater amount of erosion caused by CMP occurs with the non-annealed pad nitride layer as compared to the annealed pad nitride layer.

While the invention has been particularly shown and described with reference to various embodiments, it will be recognized by those skilled in the art that modifications and changes may be made to the present invention without departing from its scope. The scope of the invention should therefore be determined not with reference to the above description but with reference to the appended claims along with their full scope of equivalents.

## Claims

1. A method of forming integrated circuits comprising:
providing a substrate with a pad layer; and
annealing the pad layer in an nitrogen containing ambient, wherein the anneal produces a hardened pad layer with improved resistance to etch and polish rates.
